# EUROPEAN PATENT SPECIFICATION

(11) **EP 1 870 841 B1**
(45) Date of publication and mention of the grant of the patent: **01.09.2010**
(21) Application number: 07001996.3
(22) Date of filing: 30.01.2007
(51) Int. Cl.: G06K 19/077, G06K 19/07

(54) **Integrated circuit assembly including RFID and components thereof**
Integrierte Schaltungsanordnung mit RFID und Komponenten davon
Assemblage de circuit intégré comprenant un système d'identification de la fréquence radio (RFID), et les composant correspondants

(30) Priority: 21.06.2006 US 472205
(43) Date of publication of application: 26.12.2007
(73) Proprietor: Broadcom Corporation, Irvine, CA 92617 (US)
(72) Inventor: Rofougaran, Ahmadreza, Irvine, California 92618-7013 (US)
(74) Representative: Jehle, Volker Armin

(56) References cited:
- WO-A-03/085617
- US-A- 5 365 516
- US-A1- 2002 098 852
- US-B2- 6 873 259

## Description

### TECHNICAL FIELD OF THE INVENTION

This invention relates generally to integrated circuit technology and more particularly to radio frequency identification.

### DESCRIPTION OF RELATED ART

A radio frequency identification (RFID) system generally includes a reader, also known as an interrogator, and a remote tag, also known as a transponder. Each tag stores identification data for use in identifying a person, article, parcel or other object. RFID systems may use active tags that include an internal power source, such as a battery, and/or passive tags that do not contain an internal power source, but generate power from radio frequency (RF) signals received from a reader.

In general, to access the identification data stored on an RFID tag, the RFID reader generates a modulated RF interrogation signal designed to evoke a modulated RF response from a tag. The RF response from the tag includes the coded identification data stored in the RFID tag. The RFID reader decodes the coded identification data to identify the person, article, parcel or other object associated with the RFID tag. For passive tags, the RFID reader may also generate an unmodulated, continuous wave (CW) signal from which the passive tag derives its power.

RFID systems typically employ either far-field technology, in which the distance between the reader and the tag is great compared to the wavelength of the carrier signal, or near-field technology, in which the operating distance is less than one wavelength of the carrier signal. In far-field applications, the RFID reader generates and transmits an RF signal via an antenna to all tags within range of the antenna. One or more of the tags that receive the RF signal responds to the reader using a backscattering technique in which the tags modulate and reflect the received RF signal. In near-field applications, the RFID reader and tag communicate via mutual inductance between corresponding reader and tag inductors.

In RFID systems that include passive tags and employ far-field technology, a passive tag's ability to generate power from a received RF signal directly correlates to the overall efficiency and effectiveness of an RFID system. In addition, such RFID tag power generation circuits need to be small and inexpensive. One such power generation circuit is a passive rectifier cell. As is known, a passive rectifier cell includes a plurality of diodes and capacitors where, in effect, the diodes steer energy of the RF signals into the capacitors to build up a voltage. The stored voltage is then used to power the tag. While a passive rectifier cell meets the design requirements fairly well, there is loss due to the threshold voltage of the diodes and capacitor leakage. In addition, the passive rectifier cell is not a voltage doubling circuit, thus, increasing the voltage after about three cell stages is limited.

Another known power generating circuit is a charge pump that includes a plurality of cells, where each cell includes two transistors and two capacitors. Each cell operates to build a charge in one capacitor through a corresponding transistor when the phase of the RF signal is between 0 and π and builds another charge in the other capacitor through its corresponding transistor when the phase of the RF signal is between π and 2π. The charges of the capacitors are summed to produce a cell voltage. The cells are cascoded to cumulate the cell voltages to produce the resulting output voltage.

One of the biggest challenges of RFID systems is deploying the RFID tags in an efficient and economically manner. Currently, the purchase price of an RFID tag may be approximately fifty cents and the production cost of associating the RFID tag with person, article, parcel or other object may be equal to or greater than the purchase price.

US-A-6 873 259 is acknowledged in the preamble of claim 1.

Therefore, a need exists for RFID tag embodiments that enable efficient and economical deployment.

### BRIEF SUMMARY OF THE INVENTION

The invention is set out in claim 1.

Other features and advantages of the present invention will become apparent from the following detailed description of the invention made with reference to the accompanying drawings.

### BRIEF DESCRIPTION OF THE SEVERAL VIEWS OF THE DRAWING(S)

Figure 1 is a schematic block diagram of a device in accordance with the present invention;
Figure 2 is a schematic block diagram of an integrated circuit assembly in accordance with the present invention;
Figures 3-5 are diagrams of various antenna structures in accordance with the present invention;
Figures 6 and 7 are diagrams of another embodiment of an antenna structure in accordance with the present invention;
Figure 8 is a schematic block diagram of RFID tag circuitry in accordance with the present invention;
Figure 9 is a schematic block diagram of an embodiment of an integrated circuit assembly in accordance with the present invention;
Figure 10 is a schematic block diagram of another embodiment of an integrated circuit assembly in accordance with the present invention;
Figure 11 is a schematic block diagram of yet another embodiment of an integrated circuit assembly in accordance with the present invention;
Figure 12 is a logic diagram of a method for processing an RFID signal in accordance with the present invention;
Figures 13-17 are logic diagrams of various methods for interpreting an RFID signal in accordance with the present invention;
Figure 18 is a logic diagram of another method for processing RFID signals in accordance with the present invention; and
Figure 19 is a schematic block diagram of another device in accordance with the present invention.

### DETAILED DESCRIPTION OF THE INVENTION

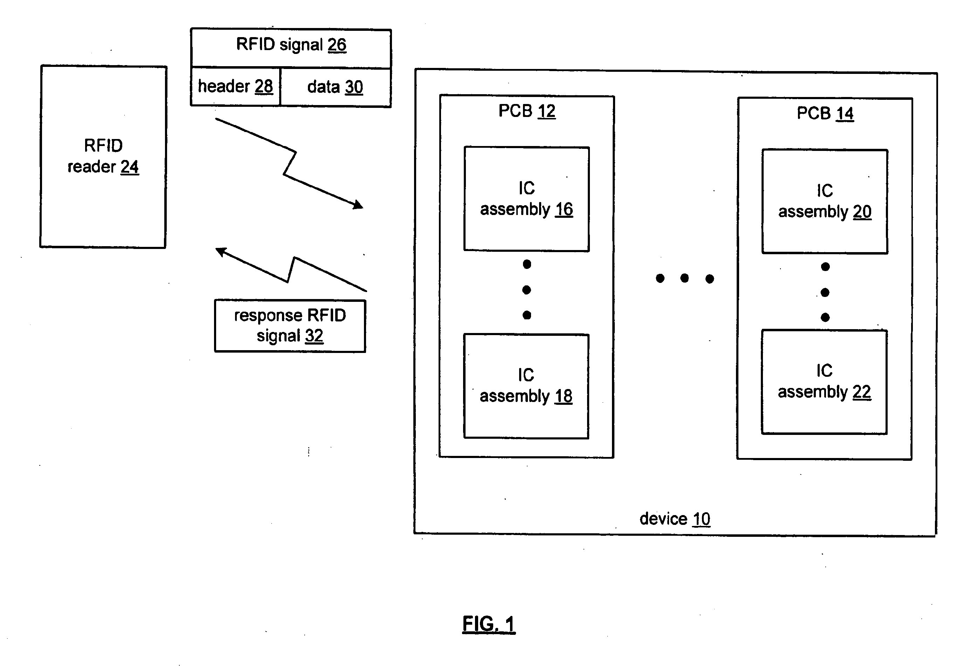

Figure 1 is a schematic block diagram of a device 10 communicating with a radio frequency identification (RFID) reader 24. The device 10 may be any type of electronic equipment that is portable and/or stationary. For example, the device 10 may be a cellular telephone, radio, portable digital entertainment system, computer, automobile circuitry, currency, credit card, personal digital assistant, television, telephone, home appliance, office equipment, identification badge, et cetera.

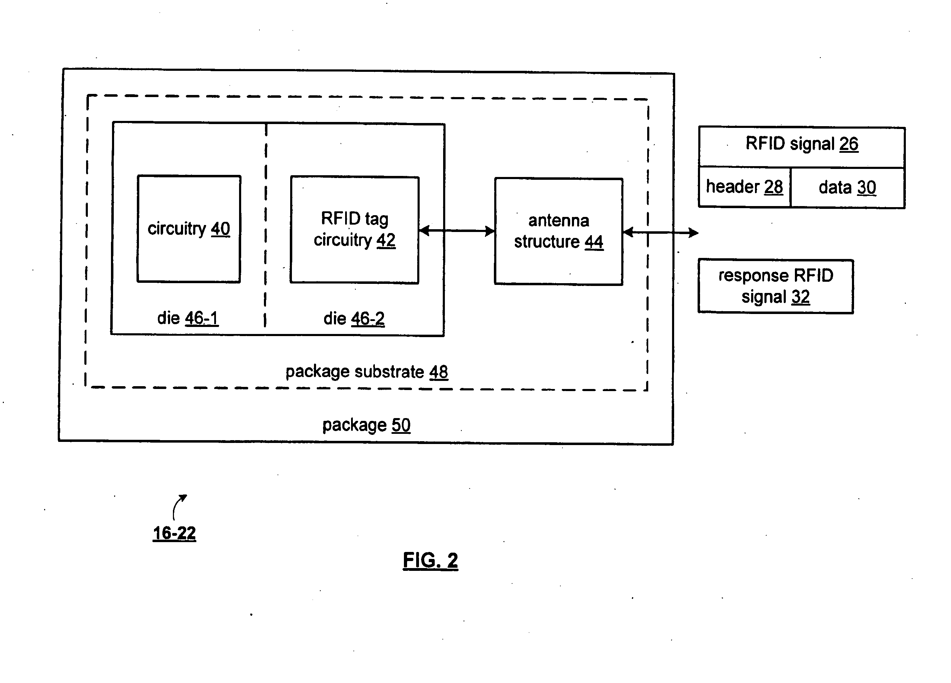

The device 10 may include one or more printed circuit boards (PCB) 12 and 14, or other supporting substrate. Each printed circuit board 12 and 14 includes one or more integrated circuit (IC) assembly 16-22. Each of the integrated circuit assemblies 16-22 includes circuitry to perform one or more functions to facilitate the operation of the device and further includes an RFID tag circuitry. Alternatively, the device may include an IC die and/or an IC assembly physically associated therewith. The integrated circuit assembly 16-22 will be described in greater detail with reference to Figures 2-19.

With the inclusion of RFID tag circuitry in an integrated circuit assembly 16-22, the device 10 is able to communicate information with an RFID reader 24. Such information may pertain to location information of the device, operational information of the device (e.g., temperature, signal processing, use, et cetera), status information of the device, and/or any other information that is desired to be communicated to a more centralized processor for compilation, tracking, et cetera.

The exchange of information between the RFID reader 24 and the device 10 commences when the RFID reader 24 provides an RFID signal 26 to the device 10. In one embodiment, the RFID signal 26 will be at a carrier frequency corresponding to the particular implementation of the RFID reader 24 and the corresponding RFID tag circuitry. For example, the carrier frequency may be 13.65 MHz, 900 MHz, and/or any other frequency that may be used for RFID applications. In another embodiment, the RF reader 24 may provide the RFID signal 26 via magnetic coupling between the reader 24 and the tag.

The RFID signal 26 includes a header portion 28 and a data portion 30. The header portion 28 may include an address of the device, of an integrated circuit assembly, and/or of a particular RFID tag circuitry. In addition, the header information may also include information regarding the particular type of response being requested. The data portion 30 includes a message, which is indicative of the information being requested concerning the device 10.

One or more of the RFID circuitries' of the IC assemblies 16-22 will respond to the RFID signal 26. Accordingly, the RFID tag circuitry will produce a response RFID signal 32 that is communicated via the same RF channel as the RFID signal 26 to the RFID reader 24.

Figure 2 is a schematic block diagram of an embodiment of an integrated circuit assembly 16-22. In this embodiment, the integrated circuit assembly 16-22 includes circuitry 40, RFID tag circuitry 42, and an antenna structure 44. The circuitry 40 is operably coupled to perform at least one function. For example, the circuitry may be a transmitter for transmitting outbound data (e.g., a wireless transmitter, a wire line transmitter such as Ethernet, et cetera), a receiver for receiving inbound signals (e.g., a wireless receiver, a wired receiver such as an Ethernet receiver, serial-to-parallel interface, et cetera), a processing module, memory, digital circuitry and/or analog circuitry. Accordingly, the function performed by the circuitry corresponds to the particular type of circuitry. For example, the processing module may perform one or more functions based on operational instructions, digital circuitry may perform corresponding digital function and analog circuitry may perform corresponding analog function. Note that if the circuitry includes a processing module, the processing module may be may be a single processing device or a plurality of processing devices. Such a processing device may be a microprocessor, micro-controller, digital signal processor, microcomputer, central processing unit, field programmable gate array, programmable logic device, state machine, logic circuitry, analog circuitry, digital circuitry, and/or any device that manipulates signals (analog and/or digital) based on hard coding of the circuitry and/or operational instructions. The processing module may have an associated memory and/or memory element, which may be a single memory device, a plurality of memory devices, and/or embedded circuitry of the processing module. Such a memory device may be a read-only memory, random access memory, volatile memory, non-volatile memory, static memory, dynamic memory, flash memory, cache memory, and/or any device that stores digital information. Note that when the processing module implements one or more of its functions via a state machine, analog circuitry, digital circuitry, and/or logic circuitry, the memory and/or memory element storing the corresponding operational instructions may be embedded within, or external to, the circuitry comprising the state machine, analog circuitry, digital circuitry, and/or logic circuitry.

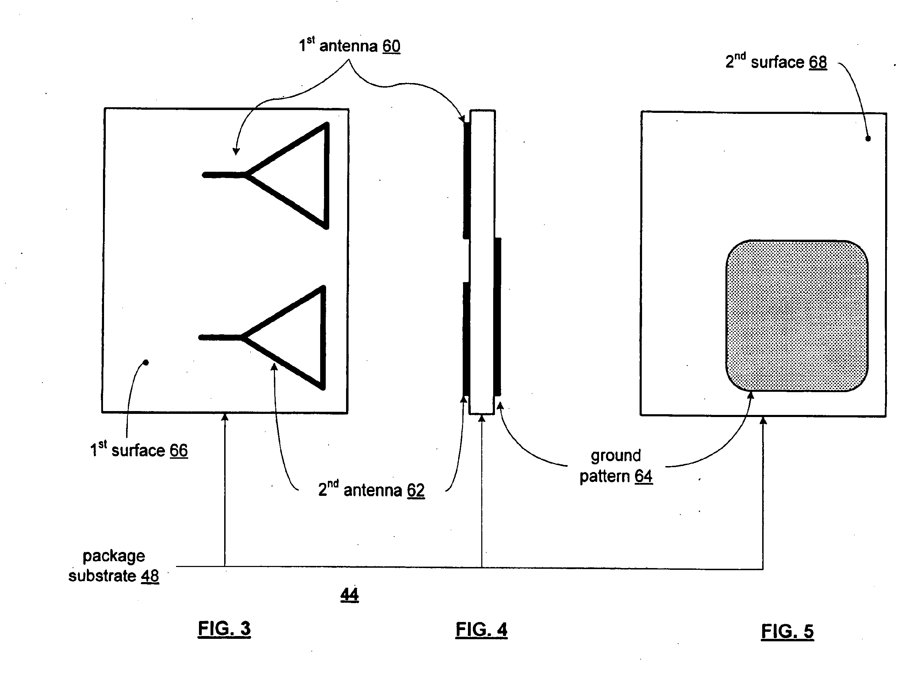

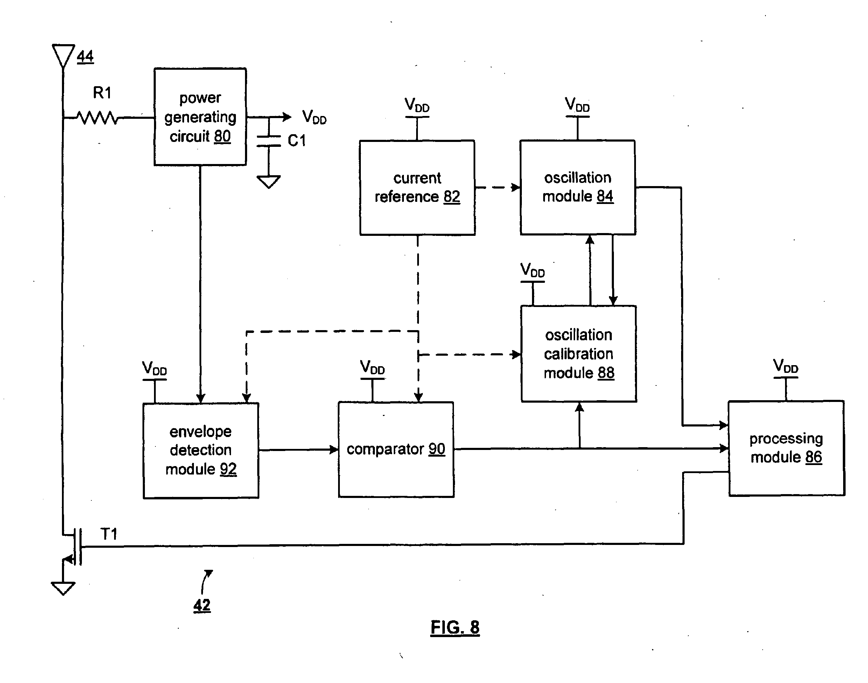

The antenna structure 44, which will be described in greater detail with reference to Figures 3-7, receives the RFID signal 26 and provides it to the RFID tag circuitry 42. The RFID tag circuitry 42, when enabled, processes the RFID signal 26 to produce the response RFID signal 32. An embodiment of the RFID tag circuitry 42 will be described in greater detail with reference to Figure 8.

Circuitry 40 and RFID tag circuitry 42 are on an integrated circuit die 46-1 and 46-2. In one embodiment, the circuitry 40 and RFID tag circuitry 42 are on the same die. In another embodiment, the circuitry 40 and RFID tap circuitry 42 are on separate dies but within the same integrated circuit package 50. In yet another embodiment, the antenna structure 44 may be on the die with the RFID tag circuitry 42 and/or the circuitry 40.

As is further shown, the integrated circuit assembly 16-22 includes a package substrate 48 within a package 50. The package substrate 48, which may be a PCB, organic substrate, and/or any other type of circuitry supporting substrate, supports the integrated circuit die 46-1 and 46-2 and further supports the antenna structure 44. The package 50 encases the package substrate 48 and may be a ball-grid array package, surface mount package, dual inline package, and/or any other type of IC package.

Figure 3-5 illustrate several embodiments of the antenna structure 44. As shown, the antenna structure may include a 15^{st} antenna 60 and a 2^{nd} antenna 62 mounted on the package substrate 48. The 1^{st} and 2^{nd} antennas 60 and 62 may be mounted on a 1^{st} surface 66 of the package substrate 48 and a ground pattern 64 may be mounted on a 2^{nd} surface 68 of the package substrate 48. The 1^{st} and 2^{nd} antennas 60 and 62 may have a meandering line configuration, a planer helical configuration, and/or board mounted antenna assembly. For a more detailed discussion of the 1^{st} and 2^{nd} antennas 70 and 72 having different polarizations refer to co-pending patent application entitled "A Planer Antenna Structure", having an Attorney Docket No. BP5263, having a Serial No. XXX and a filing date of 6/12/06.

In one embodiment, the 1^{st} and 2^{nd} antennas 60 and 62 may be arranged as a diversity antenna structure for the RFID tag circuitry. In another embodiment, the 1^{st} antenna may be utilized for the RFID tag circuitry and the 2^{nd} antenna 62 may be utilized for a wireless transmitter and/or receiver of the circuitry 40. In yet another embodiment, the RFID tag circuitry may have two or more associated antennas and the circuitry may have two or more associated antennas. In a further embodiment, the antenna structure 44 may only include a single RFID antenna, such as the 1^{st} antenna 60.

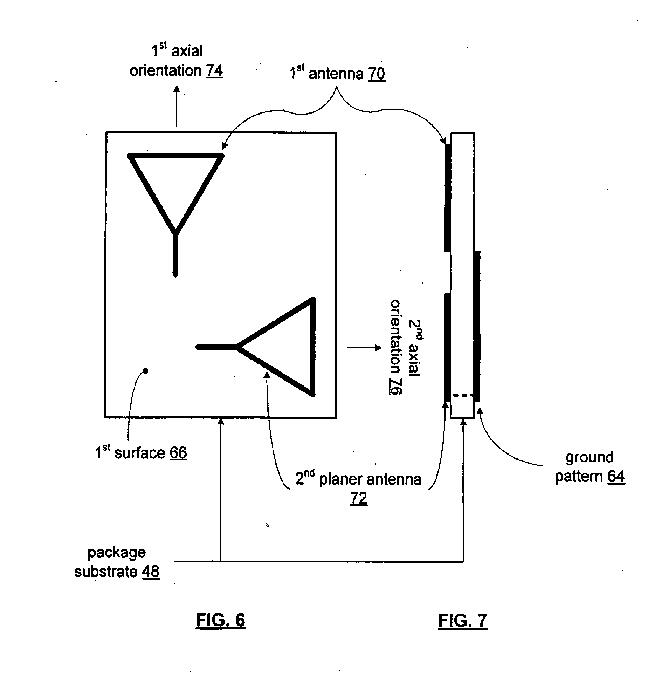

Figures 6 and 7 illustrate another embodiment of the antenna structure 44. In this embodiment the 1^{st} and 2^{nd} antennas 70 and 72 are along different axial orientations 74 and 76 (e.g., at 90° of each other). In this instance, the antennas have a different polarization. The construct of the 1^{st} and 2^{nd} antennas 70 and 72 may be a meandering line, planer helical structure, and/or board mounted antenna assembly. For a more detailed discussion of the 1^{st} and 2^{nd} antennas 70 and 72 having different polarizations refer to co-pending patent application entitled "A Planer Antenna Structure", having an Attorney Docket No. BP5263, having a Serial No. XXX and a filing date of XXX.

Figure 8 is a schematic block diagram of an embodiment of an RFID tag circuitry 42 that includes a power generating circuit 80, a current reference 82, an oscillation module 84, a processing module 86, an oscillation calibration module 88, a comparator 90, an envelope detection module 92, an optional resistor R1, a capacitor C1, and a transistor T1. The current reference 82, the oscillation module 84, the processing module 86, the oscillation calibration module 88, the comparator 90, and the envelope detection module 92 may be a single processing device or a plurality of processing devices. Such a processing device may be a microprocessor, micro-controller, digital signal processor, microcomputer, central processing unit, field programmable gate array, programmable logic device, state machine, logic circuitry, analog circuitry, digital circuitry, and/or any device that manipulates signals (analog and/or digital) based on hard coding of the circuitry and/or operational instructions. One or more of the modules 82 - 92 may have an associated memory element, which may be a single memory device, a plurality of memory devices, and/or embedded circuitry of the module. Such a memory device may be a read-only memory, random access memory, volatile memory, non-volatile memory, static memory, dynamic memory, flash memory, cache memory, and/or any device that stores digital information. Note that when the module 82 - 92 implements one or more of its functions via a state machine, analog circuitry, digital circuitry, and/or logic circuitry, the memory element storing the corresponding operational instructions may be embedded within, or external to, the circuitry comprising the state machine, analog circuitry, digital circuitry, and/or logic circuitry.

In operation, the power generating circuit 80 generates a supply voltage (V_{DD}) from a radio frequency (RF) signal that is received via an antenna and, if included, resistor R1. The power generating circuit 80 stores the supply voltage V_{DD} in capacitor C1 and provides it to modules 82 - 92.

When the supply voltage V_{DD} is present, the envelope detection module 92 determines an envelope of the RF signal, which includes a DC component corresponding to the supply voltage V_{DD}. In one embodiment, the RF signal is an amplitude modulation signal, where the envelope of the RF signal includes transmitted data. The envelope detection module 92 provides an envelope signal to the comparator 90. The comparator 90 compares the envelope signal with a threshold to produce a stream of recovered data. In an alternative embodiment, the envelope detection module 92 may be a module that extracts phase and/or frequency information from the RF signal, which is processed to produce the recovered data.

The oscillation module 84, which may be a ring oscillator, crystal oscillator, or timing circuit, generates one or more clock signals that have a rate corresponding to the rate of the data contained in the RF signal in accordance with an oscillation feedback signal.

The oscillation calibration module 88 produces the oscillation feedback signal from a clock signal of the one or more clock signals and the stream of recovered data. In general, the oscillation calibration module 88 compares the rate of the clock signal with the rate of the stream of recovered data. Based on this comparison, the oscillation calibration module 88 generates the oscillation feedback to indicate to the oscillation module 84 to maintain the current rate, speed up the current rate, or slow down the current rate.

The processing module 86, which may be included in the RFID tag circuitry 42 and/or in the circuitry 40, receives the stream of recovered data and a clock signal of the one or more clock signals. The processing module 86 interprets the stream of recovered data to determine a command or commands contained therein. The command may be to store data, update data, reply with stored data, verify command compliance, acknowledgement, etc. If the command(s) requires a response, the processing module 86 provides a signal to the transistor T1 at a rate corresponding to the RF signal. The signal toggles transistor T1 on and off to generate an RF response signal that is transmitted via the antenna. In one embodiment, the RFID tag circuitry 42 utilizing a back-scattering RF communication. Note that the resistor R1 functions to decouple the power generating circuit 80 from the received RF signals and the transmitted RF signals.

The RFID tag circuitry 42 may further include the current reference 82 that provides one or more reference, or bias, currents to the oscillation module 84, the oscillation calibration module 88, the envelope detection module 92, and the comparator 90. The bias current may be adjusted to provide a desired level of biasing for each of the modules 84, 88, 90, and 92.

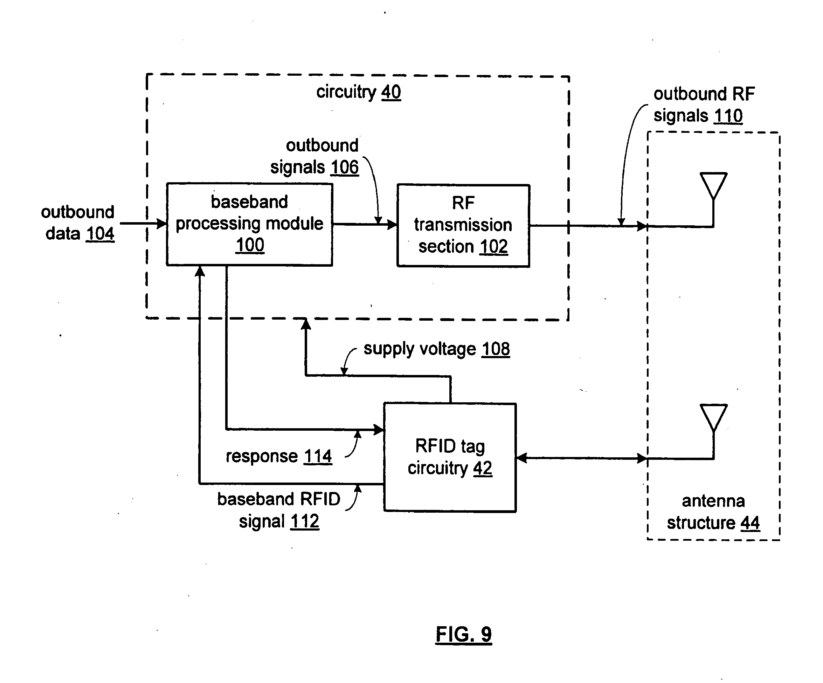

Figure 9 is a schematic block diagram of another embodiment of an integrated circuit assembly 16-22. In this embodiment, the antenna structure 44 includes one or more antennas associated with circuitry 40 and one or more antennas associated with RFID tag circuitry 42. The circuitry 40 includes a baseband processing module 100 and an RF transmission section 102. The baseband processing module 100, in accordance with one or more wireless communication protocols (e.g., Bluetooth, IEEE 802.11x, GSM, CDMA, WCDMA, et cetera), converts outbound data 104 into outbound signals 106. Such conversion may include one or more of convolutional encoding, scrambling, interleaving, symbol mapping, frequency domain to time domain conversion, and/or digital to analog domain conversion.

The RF transmission section 102 converts the outbound signals 106 into outbound RF signals 110. The RF transmission section 102 includes one or more intermediate frequency stages, a power amplifier and a local oscillator to up convert the baseband outbound signals 106 to the outbound RF signals 110.

The RFID tag circuitry 42 receives the RFID signal via the corresponding antenna and converts it to a baseband RFID signal 1.12. The RFID tag circuitry 42 provides the baseband RFID signal 112 to the baseband processing module 100. The baseband processing module 100 interprets the baseband RFID signal 112 to determine the information being requested by the RFID reader. In accordance with the RFID signal 112, the baseband processing module 100 generates a response 114, which is provided to the RFID tag circuitry 42. The RFID tag circuitry 42 converts the response 114 into a response RFID signal that is subsequently transmitted via the corresponding antenna.

In addition to or as an alternate embodiment, the RFID tag circuitry 42 provides a supply voltage 108 to circuitry 40. Circuitry 40, when in a power saving mode, may perform one or more of a plurality of low power functions (e.g., real time clocking, standby, short messaging services, query response, monitoring control channels, calibration, et cetera). In this mode, the circuitry may utilize the supply voltage 108 provided by the RFID tag circuitry 42 to either fully power the performance of the low power function and/or to subsidize the power used to perform the low power function. In general, for the supply voltage 108 to be provided to the circuitry 40, the IC assembly of Figure 9 is generally incorporated into a battery powered device.

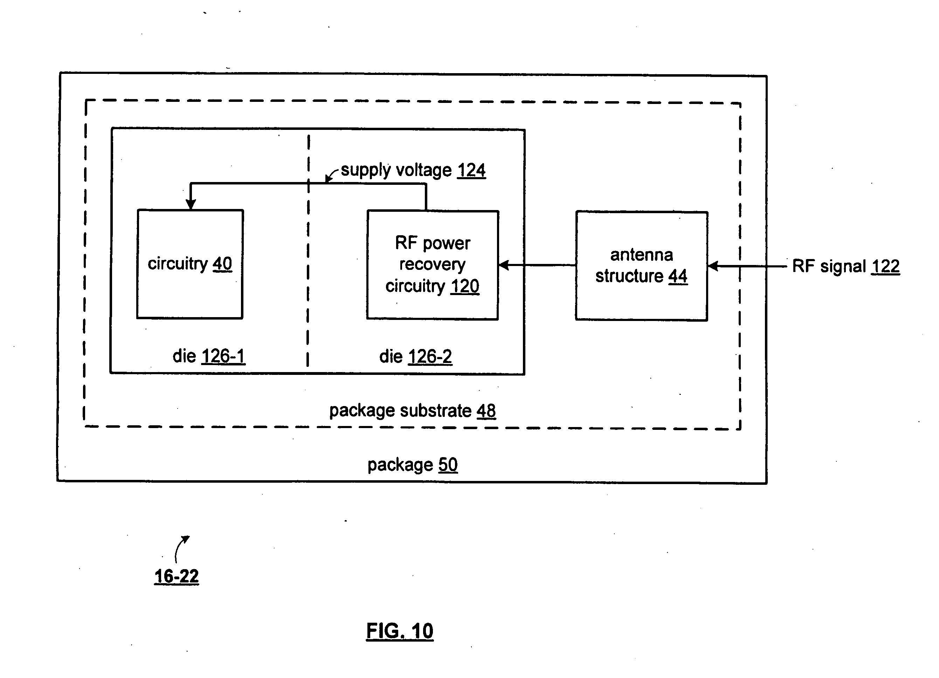

Figure 10 is a schematic block diagram of another embodiment of an integrated, circuit assembly 16-22. In this embodiment, the IC assembly includes the antenna structure 44, an RF power recovery circuit 120 and circuitry 40. As shown, circuitry 40 and the RF power recovery circuit 120 may be on the same die 126-1 and 126-2 or on different dies. The package substrate 48 supports the integrated circuit die 126-1 and 126-2 and the antenna structure 44. Package 50 encases the package substrate 48.

In this embodiment, the antenna structure 44 receives an RF signal 122 and provides it to the RF power recovery circuit 120. The RF power recovery circuit 120 converts the RF signal 122 into a supply voltage 124. The supply voltage is provided to the circuitry 40 to power, or a partially power, the circuitry to perform one or more of its functions. An embodiment of the RF power recovery circuit 120 may be similar to the power generating circuit 80 of Figure 8.

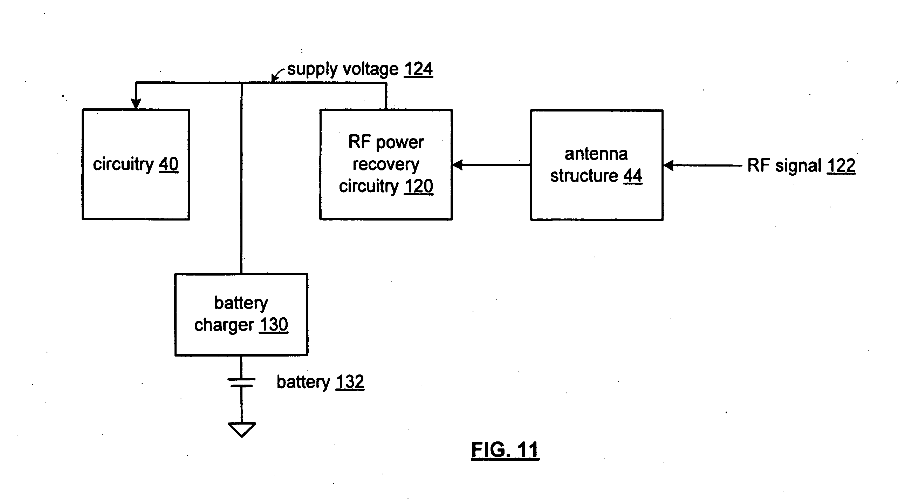

Figure 11 is a schematic block diagram of yet another embodiment of an integrated circuit assembly that includes circuitry 40, the RF power recovery circuitry 120, the antenna structure 44 and a battery charger 130. In this embodiment, the IC assembly would be included in a device 10 that is battery powered via battery 132. The battery charger 130 is coupled to convert the supply voltage 124 into a charge current for charging battery 132. As such, as long as the integrated circuit assembly is in an environment where RF signals are being received, the RF power recovery circuit 120 may generate the supply voltage 124 there from, which powers the battery charger 132. Note that when the device 10 includes multiple integrated circuit assemblies, the RF power recovery circuitries 120 may be coupled in parallel to produce the supply voltage 124 thereby providing substantially more energy than a single power recovery circuit 120.

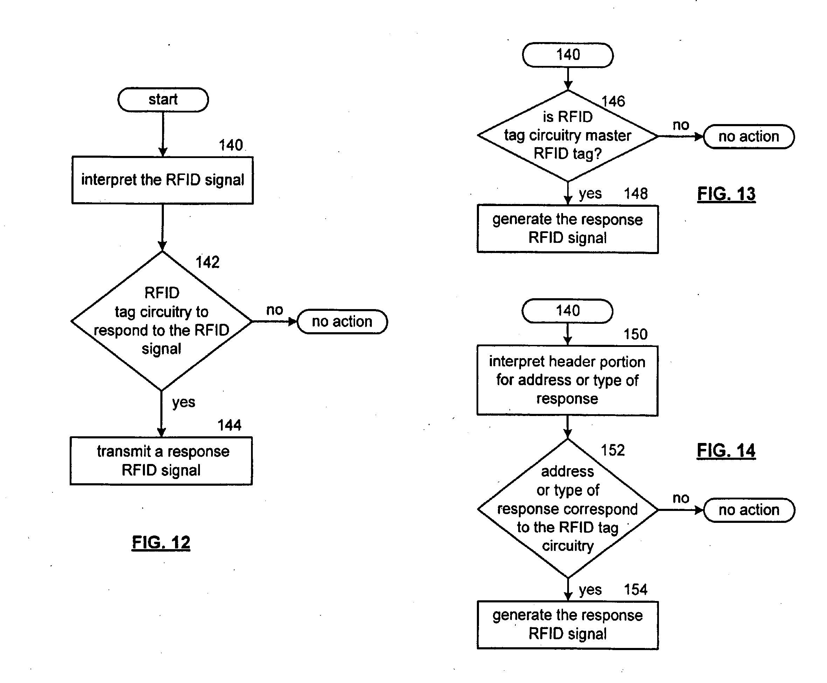

Figure 12 is a logic diagram of a method performed by one or more the RFID tag circuitries of a device 10, which, if it includes multiple integrated circuit assemblies, will include multiple RFID tag circuitries. Depending on the information being requested of the device and/or of the command, one or more of the RFID tags circuitries will be activated to provide the appropriate response and/or performance of a function in accordance with the command. The responses may range from providing location information, identification information of the device, integrated circuit assemblies, and/or function of the device, operational information of the device such as temperature, processing times, et cetera and/or any other information desired to be retrieved from embedded circuitry of the device. The commanded function may include storing data, updating information, etc.

The processing to determine whether the RFID tag circuitry of a particular integrated circuit assembly is to respond begins at Step 140 where the RFID tag circuitry interprets the RFID signal. The interpretation of the RFID signal will be described in greater detail with reference to Figures 13-17.

The process then proceeds to Step 142 where the RFID tag circuitry determines whether it is to respond to the RFID signal or perform a function. If not, no action is taken by the present RFID tag circuitry. If, however, the RFID tag circuitry is to respond, the process proceeds to Step 144 where the RFID tag circuitry transmits a response RFID signal. If the RFID tag circuitry is to perform a function, it performs the function.

The generation of the response RFID signal and/or performing the function identified in the command may be done by a processing module of the RFID tag circuitry and/or by processing module within the circuitry 40. Note that the response RFID signal will include the requested information of the RFID signal.

Figure 13 is a logic diagram of one embodiment for interpreting the RF signal. The process begins at Step 146 where a determination is made as to whether the present RFID tag circuitry is the master RFID tag. If not, no action is taken. If so, the process proceeds to Step 148 where the RFID tag circuitry generates the response RFID signal and/or performs the commanded function. In this instance, the device may be programmed, and/or hard coded to select one of the RFID tag circuits of the plurality of IC assemblies comprising the device to, function as the master RFID tag such that effectively the device only has one active RFID tag circuit.

Figure 14 is a logic diagram of another embodiment for interpreting the RFID signal at Step 140. The process begins at Step 150 where a header portion of the RFID signal is interpreted to identify and address and/or type of response and/or commanded function being requested. For example, the address may be of the device 10, the integrated circuit assembly, and/or of the RFID tag circuit. The type of response may be identification of the device, integrated circuit assembly and/or RFID tag, processing information, operational information, et cetera. The type of commanded function may be store data, update information, etc. The process then proceeds to Step 152 where determination is made as to whether the address or type of response corresponds to the particular RFID tag circuitry. If not, no action is taken.

If yes, the process proceeds to Step 154 where the present RFID tag circuitry generates the response RFID signal and/or performs the commanded function. Accordingly, the plurality of RFID tag circuitries within a device 12 may be individually addressed by an RFID reader to retrieve particular information of the device. Alternatively, the RFID tag circuitries of the device may be assigned to provide a response to a particular type of inquiry such that the RFID signal does not include specific addressing of the RFID tag circuitries, but, based on the type of response and/or type of commanded function, the RFID tag circuitries themselves figure out whether they are to respond or not. Such a system allows for distributed responsibility for responding to inquiries of the RFID reader and/or performing functions commanded by the RFID reader.

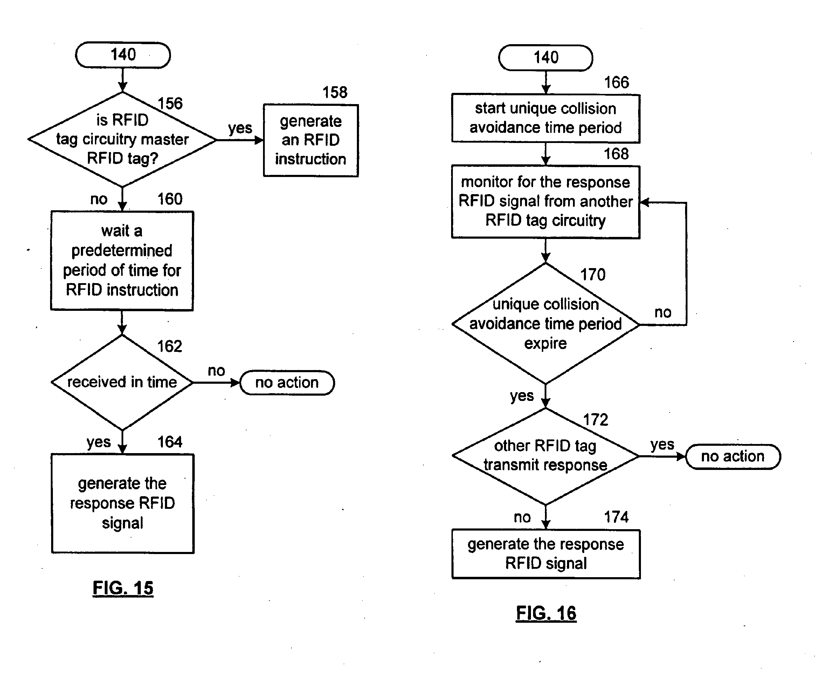

Figure 15 is a logic diagram of yet another embodiment for interpreting the RFID signal. In this embodiment the processing begins at Step 156 where determination is made as to whether the RFID tag circuitry is the master RFID tag circuit. If yes, the master may process the RFID signal as described with reference to Figure 13 or may generate an RFID instruction as shown at Step 158. The RFID instruction includes a header portion that identifies the particular RFID tag and a message to generate the RFID response and/or to perform the commanded function. In this manner, the RFID tags circuitries of the device 10 may be arranged in a hierarchical manner where the master RFID tag determines whether it will provide a response to a particular inquiry, or command, or have another one of the RFID tags perform the response to the inquiry or command. Thus, the master RFID tag may track which RFID tags have which particular responsibilities for the various types of inquiries and/or commanded functions that may be received.

If the RFID tag circuit is not the master RFID tag circuit, the process proceeds to Step 160 where the RFID tag waits for a predetermined period of time to receive the RFID instruction. The process proceeds to Step 162 where, if the RFID instruction is received in time, the processing continues on at Step 164 or no action is taken. If the RFID instruction is received in time, the process proceeds to step 164 where the RFID tag generates the RFID response signal and/or performs the commanded function.

Figure 16 is a logic diagram of yet another embodiment for interpreting the RFID signal. In this embodiment, the process begins at Step 166 where upon detecting the RFID signal and commencing with the generation and supply voltage, each of the RFID tag circuits starts a unique collision avoidance time period. Such a unique collision avoidance time period may be individually assigned to the circuits based on the processing speed of the RFID tag circuitry. For example, each RFID tag may be separated by 10 microseconds to interpret the RFID signal and to determine whether it is to provide an appropriate response and/or perform the commanded function.

The process then proceeds to Step 168 where the RFID tag circuit monitors for the response RFID signal to be transmitted by another RFID tag circuit. The process proceeds to Step 170 where a determination is made as to whether the unique collision avoidance time period has expired. If not, the process waits in a loop of Steps 168 and 170. When the unique collision avoidance time period expires, the process proceeds to Step 172 where a determination is made as to whether the RFID tag circuit has transmitted the response and/or performed the commanded function. If yes, no action is taken by the present RFID tag circuitry. If not, the process proceeds to Step 174 where the RFID tag circuitry generates the response RFID signal and/or performs the commanded function. With such an embodiment, all of the RFID tag circuitries may have overlapping responsibilities and/or capabilities to respond to the RFID signal and/or perform commanded functions. By assigning each RFID tag a unique collision avoidance time period if one RFID tag circuit fails, another will assume the responsibility and provide the appropriate response and/or perform the commanded function. One RFID tag circuitry may not respond for a variety of reasons including part failure, poor reception of the RFID signal, et cetera. Thus, this method provides a redundancy for responding to RFID signals.

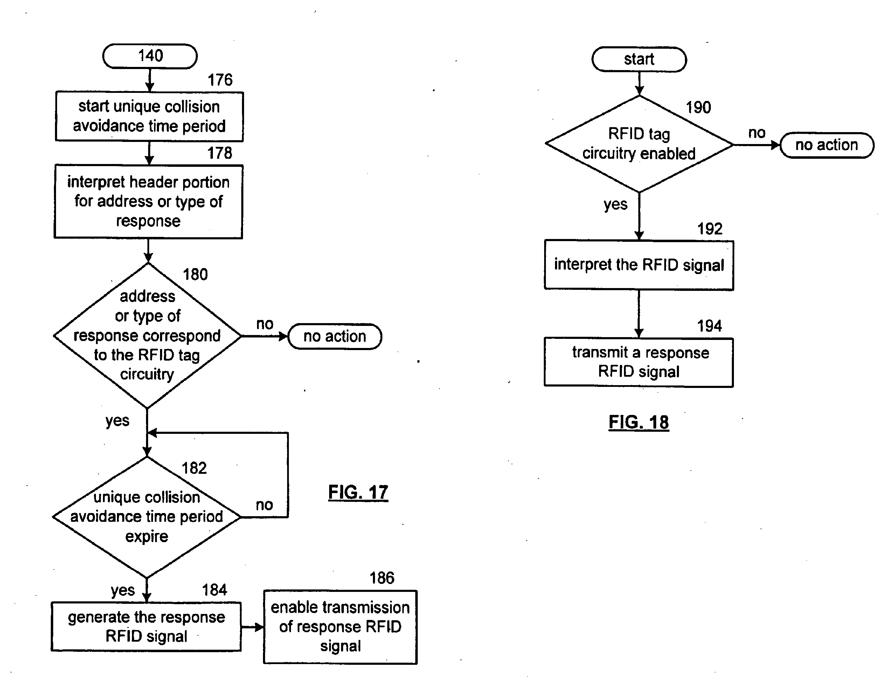

Figure 17 is a logic diagram of yet another embodiment for interpreting the RF signal. The process begins at Step 176 where each of the RFID tag circuitries starts a unique collision avoidance time period when it produces the supply voltage from the RFID signal. The process then proceeds to Step 178 where the RFID tag circuitry interprets the header portion of the RFID signal for an address and/or type of response or commanded function.

The process then proceeds to Step 180 where a determination is made as to whether the address or type of response or commanded function corresponds to the RFID tag circuitry. If not, no action is taken. If yes, the process proceeds to Step 182 where a determination is made as to whether the unique collision avoidance time period has expired. Once the time period has expired, the process proceeds to Step 184 where the RFID tag circuitry generates the response RFID signal and/or performs the commanded function. The process then proceeds to Step 186 where transmission of the response RFID signal is enabled. In this embodiment, each tag may have a responsibility to provide a portion of the information required and/or unique information based on the particular inquiry. In this manner, each RFID tag provides its portion of the response in a time sequential manner without interference from the other RFID tags. For example, this may be useful in monitoring temperatures of the various integrated circuits within a device.

Figure 18 is a logic diagram of another method for the RFID tag circuits to determine whether they should respond to an RFID signal. The process begins at Step 190 where the RFID tag circuit determines whether it is enabled. If not, no action is taken when an RFID signal is received. An RFID tag circuit may be enabled or disabled in accordance with an enable/disable signal produced by the circuitry of one or more of the IC assemblies of the device. Alternatively, each of the RFID tag circuitries may include an associated enable/disable indicator which provides the indications for whether the particular RFID tag circuitry is enabled or not. Such an enable/disable indicator may be a pin of the integrated circuit assembly, a programmable register of the integrated circuitry assembly, et cetera.

The process then proceeds to Step 192 where the RFID tag circuitry, when enabled, interprets the RFID signal. The interpretation may be done as previously described with reference to Figures 13-17. The process then proceeds to Step 194 where the RFID tag circuitry transmits the response RFID signal and/or performs the commanded function.

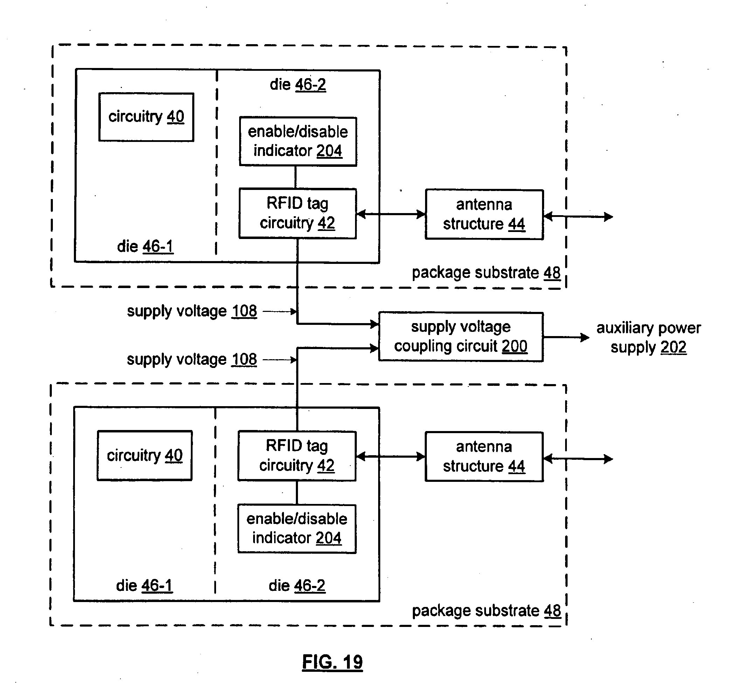

Figure 19 is a schematic block diagram of another embodiment of a device that includes multiple integrated circuit assemblies. Each integrated circuit assembly includes the package substrate 48 which supports the antenna structure 44, the RFID tag circuitry 42 and circuitry 40. In addition, each package substrate further enables/disables indicator 204 on the die 46-2. The device may further include a supply voltage coupling circuit 200 that receives the supply voltage 108 from each of the RFID tag circuitries 42 and produces there from an auxiliary power supply 202. The auxiliary power supply 202 may be used when the device is in a power saving mode whereby the supply voltage coupling circuit couples the supply voltages 108 in parallel. Note that the supply voltage coupling circuit 200 may be a printed circuit board trace, a voltage regulator assembly, a capacitor, et cetera.

As may be used herein, the terms "substantially" and "approximately" provides an industry-accepted tolerance for its corresponding term and/or relativity between items. Such an industry-accepted tolerance ranges from less than one percent to fifty percent and corresponds to, but is not limited to, component values, integrated circuit process variations, temperature variations, rise and fall times, and/or thermal noise. Such relativity between items ranges from a difference of a few percent to magnitude differences. As may also be used herein, the term(s) "coupled to" and/or "coupling" and/or includes direct coupling between items and/or indirect coupling between items via an intervening item (e.g., an item includes, but is not limited to, a component, an element, a circuit, and/or a module) where, for indirect coupling, the intervening item does not modify the information of a signal but may adjust its current level, voltage level, and/or power level. As may further be used herein, inferred coupling (i.e., where one element is coupled to another element by inference) includes direct and indirect coupling between two items in the same manner as "coupled to". As may even further be used herein, the term "operable to" indicates that an item includes one or more of power connections, input(s), output(s), etc., to perform one or more its corresponding functions and may further include inferred coupling to one or more other items. As may still further be used herein, the term "associated with", includes direct and/or indirect coupling of separate items and/or one item being embedded within another item. As may be used herein, the term "compares favorably", indicates that a comparison between two or more items, signals, etc., provides a desired relationship. For example, when the desired relationship is that signal 1 has a greater magnitude than signal 2, a favorable comparison may be achieved when the magnitude of signal 1 is greater than that of signal 2 or when the magnitude of signal 2 is less than that of signal 1.

The present invention has been described above with the aid of method steps illustrating the performance of specified functions and relationships thereof. The boundaries and sequence of these functional building blocks and method steps have been arbitrarily defined herein for convenience of description. Alternate boundaries and sequences can be defined so long as the specified functions and relationships are appropriately performed. Any such alternate boundaries or sequences are thus within the scope of the claimed invention.

The present invention has also been described above with the aid of functional building blocks illustrating the performance of certain significant functions. The boundaries of these functional building blocks have been arbitrarily defined for convenience of description. Alternate boundaries could be defined as long as the certain significant functions are appropriately performed. Similarly, flow diagram blocks may also have been arbitrarily defined herein to illustrate certain significant functionality. To the extent used, the flow diagram block boundaries and sequence could have been defined otherwise and still perform the certain significant functionality. Such alternate definitions of both functional building blocks and flow diagram blocks and sequences are thus within the scope of the claimed invention. One of average skill in the art will also recognize that the functional building blocks, and other illustrative blocks, modules and components herein, can be implemented as illustrated or by discrete components, application specific integrated circuits, processors executing appropriate software and the like or any combination thereof.

The preceding discussion has presented various embodiments for including a radio frequency identification tag circuitry in integrated circuit assemblies and as may be used by a device. As one of ordinary skill in the art will appreciate, other embodiments may be derived from the teaching of the present invention without deviating from the scope of the claims.

## Claims

1. An integrated circuit (IC) assembly comprises:
circuitry (40) operable to perform at least one function;
radio frequency identification (RFID) tag circuitry (42) coupled to process an RFID signal (26) to produce a supply voltage (V_{DD}) for the circuitry (40) and, when requested, to produce a response RFID signal (32), wherein the response RFID signal (32) includes information regarding at least one of: a device including the IC assembly (16-22), the IC assembly (16-22), and the at least one function; and
an antenna structure (44) adapted to receive the RFID signal (26) and coupled to the RFID tag circuitry (42) to provide the RFID signal (26) and to transmit the response RFID signal (32); **characterized in that** the circuitry (40) comprises
a transmitter for transmitting outbound data (104); wherein the transmitter comprises:
a baseband processing module (100) coupled to convert outbound data (104) into outbound signals (106) in accordance with at least one wireless communication protocol; and
an RF transmission section (102) coupled to convert the outbound signals (106) into outbound RFID signals (110), wherein the RF transmission section (102) is coupled to the antenna structure (44), and wherein the baseband processing module (100) interprets a baseband representation (112) of the RFID signal (26) from the tag circuitry (42), generates a response (114) thereto, and provides the response to the RFID tag circuitry (42), wherein the RFID tag circuitry (42) converts the response into the response RFID signal (32).

2. The IC assembly of claim 1 further comprises:
the circuitry (40) being on a die (46-1,46-2); and
the RFID tag circuitry (42) being on the die (46-1, 46-2).

3. The IC assembly of claim 2, wherein the circuitry (40) comprises at least one of:
a receiver for receiving inbound data;
a processing module (86);
memory;
a digital circuit; and
an analog circuit.

4. The IC assembly of claim 2 further comprises:
a package substrate (48) that supports the die (126-1, 412-2) and the antenna structure (44).

5. The IC assembly of claim 1, wherein the antenna structure (44) comprises at least one of:
an RF antenna (44);
a diversity antenna system (60, 62);
a first antenna (60) for the RF power recovery circuitry (120) and a second antenna (62) for the circuitry (40); and
third and fourth antennas (70, 72) for the RF power recovery circuitry (120), wherein the third antenna (70) has a first polarization and the fourth antenna (72) has a second polarization.

6. The IC assembly of claim 1 further comprises:
radio frequency (RF) power recovery circuit (120) coupled to produce a supply voltage (V_{DD}) from an RF signal (122);
an antenna structure (44) coupled to receive the RF signal (122) and to provide the RF signal (122) to the RF power recovery circuit (120); and
circuitry (40) coupled to receive the supply voltage (V_{DD}) when the circuitry (40) is in a power savings mode, wherein the circuitry (40) performs at least one of a plurality of low power functions.

7. The IC assembly of claim 7 further comprises:
the circuitry (40) including a wireless transceiver, wherein the plurality of low power functions includes at least two of standby mode, channel monitoring, a query response, and short messaging services.

8. The IC assembly of claim 7 further comprises:
a battery charger (130) coupled to an external battery, wherein, when the circuitry (40) is in a power savings mode, the battery charger (130) converts the supply voltage (V_{DD}) into a charge current for charging the external battery.

9. The IC assembly of claim 7 further comprises:
the circuitry (40) being on a die (46-1, 46-2); and
the RF power recovery circuit (120) being on the die (46-1, 46-2).

10. The IC assembly of claim 8 further comprises:
a package substrate (48) that supports the die (126-1, 126-2) and the antenna structure (44).

## Patentansprüche

1. Integrierte Schaltungsanordnung, die aufweist:
eine Schaltung (40), die so betreibbar ist, dass sie wenigstens eine Funktion durchführt;
eine Radio Frequency Identification (RFID)-Tag-Schaltung (42), die so gekoppelt ist, dass sie ein RFID-Signal (26) verarbeitet, um eine Versorgungsspannung (V_{DD}) für die Schaltung (40) zu erzeugen und, wenn gefordert, ein Antwort-RFID-Signal (32) zu erzeugen, wobei das Antwort-RFID-Signal (32) Informationen enthält bezüglich wenigstens einem von: einer Vorrichtung, die die integrierte Schaltungsanordnung (16-22) enthält, der integrierten Schaltungsanordnung (16-22) und der wenigstens einen Funktion; und
eine Antennenstruktur (44), die so ausgelegt ist, dass sie das RFID-Signal (26) empfängt, und die an die RFID-Tag-Schaltung (42) gekoppelt ist, um das RFID-Signal (26) bereit zu stellen, und das Antwort-RFID-Signal (32) zu senden;
**dadurch gekennzeichnet, dass** die Schaltung (40) aufweist:
einen Sender zum Senden ausgehender Daten (104), wobei der Sender aufweist:
ein Basisband-Verarbeitungsmodul (100), das so gekoppelt ist, dass es ausgehende Daten (104) in ausgehende Signale (106) gemäß wenigstens einem drahtlosen Kommunikationsprotokoll umwandelt; und
einen Hochfrequenz-Sendeabschnitt (102), der so gekoppelt ist, dass er die ausgehenden Signale (106) in ausgehende RFID-Signale (110) umwandelt, wobei der Hochfrequenz-Sendeabschnitt (102) an die Antennenstruktur (44) gekoppelt ist, und wobei das Basisband-Verarbeitungsmodul (100) eine Basisband-Repräsentation (112) des RFID-Signals (26) von der Tag-Schaltung (42) interpretiert, eine Antwort (114) darauf erzeugt, und die Antwort an die RFID-Tag-Schaltung (42) liefert, wobei die RFID-Tag-Schaltung (42) die Antwort in das Antwort-RFID-Signal (32) umwandelt.

2. Integrierte Schaltungsanordnung nach Anspruch 1, die des Weiteren aufweist:
die Schaltung (40), die sich auf einem Plättchen (die) (46-1, 46-2) befindet; und
die RFID-Tag-Schaltung (42), die sich auf dem Plättchen (46-1, 46-2) befindet.

3. Integrierte Schaltungsanordnung nach Anspruch 2, wobei die Schaltung (40) wenigstens eines aufweist von:
einen Empfänger zum Empfangen eingehender Daten;
ein Verarbeitungsmodul (86);
einen Speicher;
eine digitale Schaltung; und
eine analoge Schaltung.

4. Integrierte Schaltungsanordnung nach Anspruch 2, die des Weiteren aufweist:
ein Paketsubstrat (48), das das Plättchen (126-1, 412-2) und die Antennenstruktur (44) stützt.

5. Integrierte Schaltungsanordnung nach Anspruch 1, wobei die Antennenstruktur (44) wenigstens eines aufweist von:
einer Hochfrequenzantenne (44);
einem Diversitätsantennensystem (60, 62);
einer ersten Antenne (60) für die Hochfrequenz-Leistungsrückgewinnungsschaltung (120) und eine zweite Antenne (62) für die Schaltung (40); und
dritten und vierten Antennen (70, 72) für die Hochfrequenz-Leistungsrückgewinnungsschaltung (120), wobei die dritte Antenne (70) eine erste Polarisation und die vierte Antenne (72) eine zweite Polarisation hat.

6. Integrierte Schaltungsanordnung nach Anspruch 1, die des Weiteren aufweist:
eine Hochfrequenz-Leistungsrückgewinnungsschaltung (120), die so gekoppelt ist, dass sie eine Versorgungsspannung (V_{DD}) aus einem Hochfrequenzsignal (122) erzeugt;
eine Antennenstruktur (44), die so gekoppelt ist, dass sie das Hochfrequenzsignal (122) empfängt und das Hochfrequenzsignal (122) an die Hochfrequenz-Leistungsrückgewinnungsschaltung (120) liefert; und
eine Schaltung (40), die so gekoppelt ist, dass sie die Versorgungsspannung (V_{DD}) empfängt, wenn sich die Schaltung (40) in einem Energiesparmodus befindet, wobei die Schaltung (40) wenigstens eine einer Vielzahl von Niedrigenergiefunktionen durchführt.

7. Integrierte Schaltungsanordnung nach Anspruch 7, die des Weiteren aufweist:
die Schaltung (40) mit einem drahtlosen Transceiver, wobei die Vielzahl von Niedrigenergiefunktionen wenigstens zwei umfasst von Standby-Modus, Kanalüberwachung, Anfrageantwort und Kurznachrichten-Diensten.

8. Integrierte Schaltungsanordnung nach Anspruch 7, die des Weiteren aufweist:
ein Batterieladegerät (130), das an eine externe Batterie gekoppelt ist, wobei, wenn sich die Schaltung (40) in einem Energiesparmodus befindet, das Batterieladegerät (130) die Versorgungsspannung (V_{DD}) in einen Ladestrom zum Laden der externen Batterie umwandelt.

9. Integrierte Schaltungsanordnung nach Anspruch 7, die des Weiteren aufweist:
die Schaltung (40), die sich auf einem Plättchen (46-1, 46-2) befindet; und
die Hochfrequenz-Leistungsrückgewinnungsschaltung (120), die sich auf dem Plättchen (46-1, 46-2) befindet.

10. Integrierte Schaltungsanordnung nach Anspruch 8, die des Weiteren aufweist:
ein Paketsubstrat (48), das das Plättchen (126-1, 126-2) und die Antennenstruktur (44) stützt.

## Revendications

1. Assemblage de circuit intégré (IC) comprenant :
un circuit (40) utilisable pour exécuter au moins une fonction ;
un circuit d'étiquette d'identification par radiofréquence (RFID) (42) couplée pour traiter un signal RFID (26) pour produire une tension d'alimentation (V_{DD}) pour le circuit (40) et, quand nécessaire, pour produire un signal RFID de réponse (32), dans lequel le signal RFID de réponse (32) comprend des informations concernant au moins un élément parmi : un dispositif comprenant l'assemblage de circuit intégré (16-22), l'assemblage de circuit intégré (16-22) et l'au moins une fonction ; et
une structure d'antenne (44) adaptée pour recevoir le signal RFID (26) et couplée au circuit d'étiquette RFID (42) pour fournir le signal RFID (26) et pour transmettre le signal RFID de réponse (32) ; **caractérisé en ce que** le circuit (40) comprend
un émetteur pour transmettre des données sortantes (104) ; dans lequel l'émetteur comprend :
un module de traitement de bande de base (100) couplé pour convertir les données sortantes (104) en signaux sortants (106) conformément à au moins un protocole de communication sans fil ; et
une section de transmission RF (102) couplée pour convertir les signaux sortants (106) en signaux RFID sortants (110), dans lequel la section de transmission RF (102) est couplée à la structure d'antenne (44), et dans lequel le module de traitement de bande de base (100) interprète une représentation de bande de base (112) du signal RFID (26) provenant du circuit d'étiquette RFID (42), génère une réponse (114) à celle-ci et fournit la réponse au circuit d'étiquette RFID (42), dans lequel le circuit d'étiquette RFID (42) convertit la réponse en signal RFID de réponse (32).

2. Assemblage de circuit intégré selon la revendication 1, comprenant en outre :
le circuit (40) qui est placée sur la puce (46-1, 46-2) ; et
le circuit d'étiquette RFID (42) qui est placée sur une puce (46-1, 46-2).

3. Assemblage de circuit intégré selon la revendication 2, dans lequel le circuit (40) comprend au moins un élément parmi :
un récepteur pour recevoir des données entrantes ;
un module de traitement (86) ;
une mémoire ;
un circuit numérique ; et
un circuit analogique.

4. Assemblage de circuit intégré selon la revendication 2, comprenant en outre :
un substrat de groupe (48) qui supporte la puce (126-1, 412-2) et la structure d'antenne (44).

5. Assemblage de circuit intégré selon la revendication 1, dans lequel la structure d'antenne (44) comprend au moins un élément parmi :
une antenne RF (44) ;
un système d'antennes de diversité (60, 62) ;
une première antenne (60) pour le circuit de récupération de puissance RF (120) et une deuxième antenne (62) pour le circuit (40) ; et
des troisième et quatrième antennes (70, 72) pour le circuit de récupération de puissance RF (120),
dans lequel la troisième antenne (70) a une première polarisation et la quatrième antenne (72) a une seconde polarisation.

6. Assemblage de circuit intégré selon la revendication 1, comprenant en outre :
un circuit de récupération de puissance de radiofréquence (RF) (120) couplé pour produire une tension d'alimentation (V_{DD}) à partir d'un signal RF (122) ;
une structure d'antenne (44) couplée pour recevoir le signal RF (122) et pour fournir le signal RF (122) au circuit de récupération de puissance RF (120) ; et
le circuit (40) couplée pour recevoir la tension d'alimentation (V_{DD}) quand le circuit (40) est dans un mode d'économie d'énergie, dans lequel le circuit (40) exécute au moins une fonction parmi une pluralité de fonctions à basse puissance.

7. Assemblage de circuit intégré selon la revendication 7, comprenant en outre :
le circuit (40) comprenant un émetteur-récepteur sans fil, dans lequel la pluralité de fonctions à basse puissance comprend au moins deux fonctions parmi un mode de veille, un monitorage de canal, une réponse d'interrogation et des services de messages courts.

8. Assemblage de circuit intégré selon la revendication 7, comprenant en outre :
un chargeur de batterie (130) couplé à une batterie externe, dans lequel, quand le circuit (40) est dans un mode d'économie d'énergie, le chargeur de batterie (130) convertit la tension d'alimentation (V_{DD}) en un courant de charge pour charger la batterie externe.

9. Assemblage de circuit intégré selon la revendication 7, comprenant en outre :
le circuit (40) qui est placée sur une puce (46-1, 46-2) ; et
le circuit de récupération de puissance RF (120) qui est placé sur la puce (46-1, 46-2).

10. Assemblage de circuit intégré selon la revendication 8, comprenant en outre :
un substrat de groupe (48) qui supporte la puce (126-1, 126-2) et la structure d'antenne (44).
